# FASCICULE DE BREVET EUROPEEN

(11) **EP 1 349 280 B1**
(45) Date de publication et mention de la délivrance du brevet: **11.03.2009**
(21) Numéro de dépôt: 03100728.9
(22) Date de dépôt: 21.03.2003
(51) Int. Cl.: H03K 17/955

(54) **Système de détection de présence étanche notamment pour une poignée d'ouvrant**
Wasserdichtes Anwesenheitssensorsystem, insbesondere für Türgriffe
Tight presence detection system, particularly for door handles

(30) Priorité: 21.03.2002 FR 0203719
(43) Date de publication de la demande: 01.10.2003
(73) Titulaire: VALEO SECURITE HABITACLE S.A.S., 94042 Créteil Cédex (FR)
(72) Inventeur: Derouet, Hugues, 94042, Créteil (FR); Gehin, Frédéric, 94042, Créteil (FR)
(74) Mandataire: Rosolen-Delarue, Katell

(56) Documents cités:
- FR-A- 2 779 889
- US-A- 4 380 040
- US-B1- 6 249 130

## Description

La présente invention concerne un système de détection de présence d'un utilisateur.

L'invention concerne plus particulièrement un système de détection de présence d'un utilisateur au niveau ou à proximité d'une paroi accessible par sa surface extérieure à l'utilisateur.

On connaît des systèmes de détection de présence d'un utilisateur, comprenant un capteur de présence positionné en regard d'une surface interne d'une paroi accessible par sa surface externe à l'utilisateur, dans lesquels la détection de présence de l'utilisateur est réalisée lorsque ce dernier se trouve au niveau ou à proximité de la surface externe de la paroi, c'est à dire lorsqu'il entre dans une zone de détection de présence associée au capteur.

Dans ces systèmes connus, le capteur de présence est généralement inséré dans un logement qu'il est nécessaire de concevoir étanche, de sorte que le capteur est totalement protégé des intempéries et fonctionne en toutes conditions, par exemple dans une poignée d'ouvrant.

Cependant, dans certains systèmes, par exemple dans une poignée d'ouvrant de véhicule, il n'est pas possible de disposer de logements étanches pour positionner le capteur de présence. Dans ces conditions, des matériaux conducteurs, par exemple des gouttes d'eau ou des résidus graisseux chargés de particules métalliques, peuvent venir s'interposer entre le capteur de présence et la surface interne de la paroi du logement et établir un film conducteur entre le capteur et la paroi du logement.

L'établissement d'un film conducteur au niveau du capteur de présence, en particulier lorsqu'il fonctionne sur le principe de détection d'une variation de capacité, peut générer différents phénomènes :
- Une diminution de la sensibilité de détection entraînant un risque de non détection, ou
- Une variation de couplages électromagnétiques augmentant les risques de fausses détections.

Dans les deux cas précités, le capteur de détection de présence n'est plus fiable.

Par ailleurs, selon la nature du phénomène physique utilisé pour la détection de présence, il est également important de s'assurer que le capteur de présence n'est pas à une distance trop importante de la paroi, de sorte que l'on est toujours assuré d'avoir une détection de présence lorsque l'utilisateur s'approche de la paroi.

Un but de la présente invention est de pallier ces inconvénients et de proposer une solution permettant de s'affranchir de logements étanches.

US 6 249 130 décrit l'art antérieur.

A cet effet, l'invention propose un système de détection de présence d'un utilisateurtel que revendiqué dans la revendication 1.

Ainsi, entre la surface active du capteur de présence et la surface interne de la paroi accessible par sa surface externe à l'utilisateur, on positionne une couche d'un matériau électriquement isolant de manière qu'il remplisse totalement l'espace situé entre la surface interne de la paroi et la surface active du capteur de présence pour créer une étanchéité à l'introduction de toute matière conductrice dans cet espace.

Par surface active, on entend la zone de surface du capteur comprenant les composants générant la zone de détection de présence. Par exemple, dans le cas d'un capteur capacitif comportant des électrodes, la surface active est définie par la surface sur laquelle s'étendent les électrodes.

La couche électriquement isolante permet d'empêcher l'introduction de toute matière conductrice parasite entre la surface interne de la paroi et la surface du capteur en regard.

Selon un mode de réalisation préférentiel de l'invention, le matériau non conducteur est un matériau souple et/ou malléable de sorte qu'il s'adapte, d'une part, au profil de la surface interne de la paroi et d'autre part, au profil de la surface du capteur de présence située en regard.

Ainsi, le capteur de présence peut s'adapter à la forme de la paroi lorsque celle-ci présente une forme courbe ou irrégulière.

Avantageusement, le matériau non conducteur est une mousse ou un film pour une mise en place aisée.

Le système de détection selon l'invention comporte, en outre, des moyens de fixation pour maintenir le capteur de présence en regard de ladite surface interne de la paroi présentant, seules ou en combinaison, les alternatives suivantes :
- les moyens de fixation permettent d'exercer une pression sur la couche électriquement isolante de sorte que celle-ci est maintenue en position.
- les moyens de fixation présentent de plus des moyens pour le positionnement du capteur de présence à une distance prédéterminée de la surface externe de la paroi, de sorte que la distance entre la surface externe de la paroi et la surface du capteur de présence située en regard de la surface interne soit approximativement constante.

De manière avantageuse, le capteur de présence est un capteur tactile permettant la détection d'une action de toucher d'un utilisateur au niveau de la surface externe de la paroi en regard dudit capteur, et/ou un capteur d'approche permettant la détection d'un utilisateur dans une zone de détection de présence située à proximité de la surface externe de la paroi en regard dudit capteur.Selon une caractéristique supplémentaire, le capteur de présence comprend un boîtier support dans lequel sont intégrés au moins partiellement un module électronique de contrôle, une électrode de mesure et une électrode de référence.

L'invention a également pour objet un système de détection de présence dans lequel la paroi forme une partie de poignée d'ouvrant.

L'invention sera mieux comprise au cours de la description explicative détaillée d'exemples non limitatifs faisant références aux figures annexées qui représentent :
- Figure 1, une vue en coupe transversale d'un système de détection de présence selon l'invention,
- Figure 2, une vue en coupe longitudinale d'un système de détection de présence selon l'invention positionné au niveau d'une paroi courbe,
- Figure 3, une vue en coupe longitudinale d'un système de détection de présence selon l'invention positionné au niveau d'une paroi présentant différentes pentes,
- Figures 4a et 4b, deux vues en coupe longitudinale d'un système de détection de présence selon un mode de réalisation de l'invention intégrant des moyens de fixation,
- Figures 5a, 5b, 5c, différentes vues en coupe d'une poignée d'ouvrant présentant l'intégration d'un système de détection de présence selon l'invention,
- Figures 6a et 6b, deux vues en coupe d'une poignée d'ouvrant intégrant un système de détection de présence selon l'invention et présentant son mode de fixation.

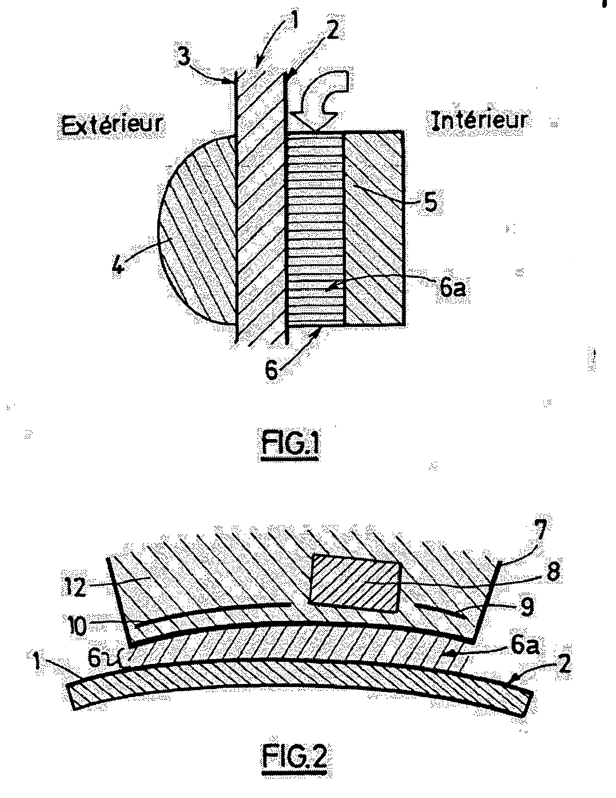

La figure 1 présente une vue schématique en coupe transversale d'un système de détection de présence selon un mode de réalisation préféré de l'invention.

La figure 1 montre une paroi 1, présentant une surface interne 2 et une surface externe 3, qui permet la séparation entre un espace intérieur et un espace extérieur accessible à un utilisateur.

Un capteur de présence 5 est positionné en regard de la surface interne 2 et permet de définir, à proximité de la surface externe 3 de la paroi 1 accessible à l'utilisateur, une zone de détection de présence 4 de l'utilisateur.

Selon un mode de réalisation de l'invention, l'espace situé entre la surface interne 2 et la surface du capteur de présence 5 située en regard est comblé totalement par un couche isolante électriquement 6 de façon à empêcher l'introduction de toute matière conductrice parasite entre le la surface interne 2 et la surface du capteur en regard.

Dans l'absolu, et sans se départir du cadre de l'invention, il suffit de combler, par la couche isolante, l'espace située entre la surface interne 2 et la surface active du capteur de présence.

La présence de cette couche isolante électriquement 6 permet de créer une étanchéité entre le capteur de présence 5 et la surface interne 2 de la paroi 1. Aucun élément conducteur, tel que de l'eau par exemple, ne peut venir s'interposer entre le capteur et la paroi, permettant ainsi de diminuer le risque de fausses détections.

Grâce à l'invention on a ainsi réalisé un arrangement d'un capteur de présence 5 en regard d'une surface interne 2 d'une paroi 1 accessible par sa surface externe 3 à l'utilisateur, dans lequel une couche électriquement isolante 6 d'au moins un matériau non conducteur remplissant totalement l'espace situé entre la surface interne 2 et au moins la surface active du capteur de présence 5 est insérée. Cette couche de matériau isolant 6 permet de créer une étanchéité à l'introduction de toute matière conductrice entre l'espace situé entre la surface interne 2 et au moins la surface active du capteur de présence 5 pour empêcher toute perturbation de la zone de détection 4 du capteur de présence 5 et diminuer les risque de fausses détection.

En effet, la diminution du risque de fausses détections est particulièrement nécessaire pour augmenter la fiabilité du système notamment lorsqu'une détection de présence entraîne l'actionnement d'un organe ou la mise en fonctionnement d'une fonction particulière.

Ainsi, dans les systèmes d'accès mains libres de véhicules automobile par exemple, la détection d'un utilisateur permet d'initier une communication entre le véhicule et un organe identifiant l'utilisateur pour permettre ensuite le déverrouillage ou le verrouillage du véhicule.

La nécessité de réduire le risque de fausses détection apparaît donc clairement de façon à éviter que le système ne fonctionne de manière intempestive.

Bien entendu, ce principe peut s'appliquer à tout type de capteur capacitif en plaçant la matière électriquement isolante 6 au bon endroit par rapport aux composants du capteur formant la surface active du capteur.

La figure 2 présente une vue en coupe longitudinale du système de détection de présence de la figure 1 positionné au niveau d'une paroi courbe. La paroi 1 séparant un espace intérieur et un espace extérieur n'est pas plane mais courbe ce qui a pour conséquence que la disposition du capteur est plus complexe.

Dans ce mode de réalisation, le capteur de présence 5 est un capteur capacitif fonctionnant sur le principe de détection d'une variation de capacité provoquée par la présence d'un utilisateur.

Ce capteur 5 comprend un boîtier support 7 dont la surface en regard de la paroi 1 est courbe et dans lequel sont intégrés un module électronique de contrôle 8, une électrode de référence 9 et une électrode de mesure 10.

Lorsque le capteur est mis en fonctionnement, un couplage électromagnétique s'établit entre les deux électrodes 9 et 10 et génère une zone de détection de présence de l'utilisateur (non représentée) au niveau de la paroi 1.

Dans le cas présent, la zone de détection de présence 4 est donc constituée par la zone dans laquelle s'étend le couplage électromagnétique établit entre les électrodes 9 et 10 du capteur de présence 5.

Ainsi, lorsqu'un utilisateur s'approche de la paroi par sa surface extérieure et pénètre dans la zone de détection associée au capteur de présence, sa présence est détectée.

Cet arrangement du matériau non conducteur 6 de manière à remplir totalement l'espace situé entre la surface interne 2 et au moins la surface active du capteur de présence 5 située en regard permet de créer une étanchéité à toute matière conductrice pour empêcher toute perturbation du couplage électromagnétique au niveau de l'espace situé entre la surface interne 2 et au moins la surface active du capteur de présence 5 et ainsi éviter une modification non-désirée de la zone de détection associée au capteur de présence 5.

Les différents éléments présents dans le boîtier support 7 sont protégés par une résine 12 surmoulée à basse pression et basse température lors de la fabrication du capteur. Le boîtier support est généralement réalisé dans un matériau rigide mais il est également possible de le réaliser dans un matériau souple.

La couche isolante électriquement 6 assurant l'étanchéité est composée d'un matériau non conducteur élastique 6a qui présente des propriétés de souplesse et/ou malléabilité.

Ces propriétés particulièrement intéressantes permettent au matériau de s'adapter d'une part au profil de la surface interne 2 de la paroi 1 et d'autre part au profil de la surface du capteur de présence ou du boîtier 7 du capteur de présence située en regard.

L'utilisation d'un matériau souple permet qu'il remplisse tout l'espace situé entre la paroi et le capteur et absorbe les irrégularités de surface.

L'utilisation d'un matériau malléable permet de le conformer lors de sa mise en place dans l'espace situé entre la paroi et le capteur.

Dans le cas présent, le matériau non conducteur, grâce à ses propriétés élastiques, permet également d'assurer l'adaptation de courbure entre le capteur de présence et la surface interne de la paroi.

Il est constitué par exemple d'un plastique d'injection, d'un plastique de surmoulage, d'une couche de silicone rapportée ou encore d'un mousse imperméable et compressible.

Pour le montage du système de détection, on dispose de plusieurs solutions :
- Fixation, par collage par exemple, du matériau non conducteur sur la paroi et mise en place du capteur de présence,
- Fixation du matériau non conducteur sur le capteur ou son boîtier et mise en place de l'ensemble en regard de la surface interne de la paroi,
- Fixation du boîtier en regard de la paroi et remplissage de l'espace situé entre ces deux éléments par le matériau non conducteur.

De manière préférentielle et dans le but d'obtenir une meilleure adaptation du matériau non conducteur à l'espace situé entre la surface interne de la paroi 1 et la surface du capteur de présence située en regard, on préférera la dernière solution proposée. Le matériau non conducteur sera introduit, lors du montage du système, dans cet espace sous la forme d'un fluide polymérisant.

La polymérisation de ce fluide pourra se faire à l'air ou en température après sa mise en place. En variante, le fluide utilisé peut être thermodurcissable.

Grâce à cette disposition particulière, l'étanchéité entre la surface interne de la paroi et la surface du capteur située en regard est particulièrement bien faite puisque, lors de la polymérisation du fluide, tout l'espace situé entre ces deux éléments vient à être comblé.

En conclusion, l'utilisation d'un matériau souple, au moins dans sa phase de mise en place, est particulièrement intéressante.

De manière équivalente, l'utilisation d'un empilement de matériaux non conducteurs sous la forme d'une couche isolante électriquement pourra être envisagée.

Comme on vient de le voir, les propriétés physiques et chimiques du matériau non conducteur sont très importantes et permettent de faciliter le montage du système, d'obtenir une bonne étanchéité du système de détection et enfin de contrôler la distance entre le capteur de présence et la surface externe de la paroi accessible à l'utilisateur.

De manière supplémentaire, le choix d'un matériau présentant également des propriétés adhésives, permet au moins partiellement la fixation du capteur sur la surface interne de la paroi.

Sur la figure 2, la couche électriquement conductrice 6 remplit totalement l'espace entre le fond du boîtier et la paroi. En variante, on pourrait se limiter à remplir l'espace entre les zones actives du capteur, à savoir, dans le cas présent, les zones de boîtier en regard avec les électrodes 9 et 10, et la surface interne de la paroi 1.

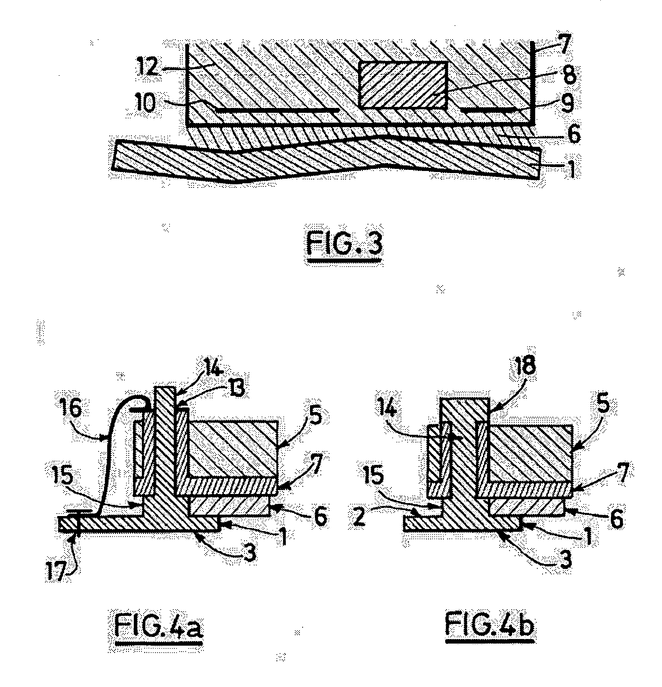

La figure 3 est une vue similaire à celle de la figure 2, dans laquelle, la paroi 1 est irrégulière et présente différentes pentes.

La paroi 1 possède des parties ayant différentes pentes et n'est donc pas plane.

Le capteur de présence 5 est le même que celui de la figure 2 et son architecture ne sera pas reprise. Le boîtier support 7 présente la différence que sa surface en regard de la paroi 1 est plane.

Ainsi qu'on le voit, la couche de matériau non conducteur 6 permet une adaptation entre la surface interne de la paroi et la surface du boîtier support 7 en regard de manière que la distance entre ces deux surfaces soit approximativement constante. En effet, il est important de contrôler que le capteur de présence n'est pas à une distance trop importante de la paroi pour que la zone de détection générée puisse être perturbée par l'utilisateur lorsqu'il s'approche de la paroi et ainsi aboutir à une détection de présence.

Les figures 4a et 4b présentent deux vues en coupe longitudinale d'un système de détection de présence selon l'invention intégrant des moyens de fixation.

Dans certains cas où le matériau non conducteur ne présente pas de propriétés adhésives, il est souhaitable d'avoir des moyens de fixation pour maintenir, d'une part, le capteur de présence en regard de la surface interne de la paroi et d'autre part, le matériau non conducteur entre la paroi et le capteur.

On a représenté sur les figures 4a et 4b, une paroi 1 présentant une surface interne 2 et une surface externe 3. Cette paroi possède un picot 14 avec un épaulement 15, par exemple venus de matière avec la paroi.

Le capteur de présence 5 est muni d'un boîtier support 7 possédant un logement 13 de forme complémentaire à celle du picot 14 de la paroi 1.

Ainsi, lors du montage du système, le boîtier support 7 du capteur est inséré par son logement 13 sur le picot 14 et les parois du boîtier en regard de la surface interne 2 viennent en appui sur l'épaulement 15.

De manière à maintenir le capteur de présence positionné en regard de la paroi, un moyen de pression est utilisé.

Sur la figure 4a, le moyen de pression est réalisé sous la forme d'un clip 16 dont une extrémité est vissée par une vis 17 sur la surface interne 2 de la paroi et dont l'autre extrémité vient en appui sur le boîtier support 7.

Sur la figure 4b, le moyen de pression est réalisé par bouterollage. Après positionnement du capteur de présence sur le picot 14, l'extrémité supérieure du picot 14 est fondue ou aplatie, selon la matière dans laquelle est réalisée le picot, pour former un second épaulement 18. Le capteur de présence se trouve ainsi maintenu entre le premier 15 et le second 18 épaulement.

Ces différents moyens de fixation permettent d'exercer une pression sur la couche de matériau non conducteur pour que celle-ci soit maintenue en position.

De façon préférentielle et pour que l'étanchéité entre le capteur de présence et la paroi soit maximale, l'épaisseur de la couche de matériau non conducteur sera plus importante que la hauteur de l'épaulement 15. Ainsi, lorsque les moyens de fixations seront mis en place, le matériau non conducteur se trouvera comprimé et remplira totalement l'espace situé entre la surface interne de la paroi et la surface du capteur de présence située en regard.

Comme décrit ci-dessus, les moyens de fixation présentent des moyens permettant le positionnement du capteur de présence à une distance prédéterminée de la surface externe de la paroi de sorte que la distance entre la surface externe de la paroi et la surface du capteur de présence située en regard de la surface interne soit approximativement constante. Ces moyens de positionnement sont réalisés sous la forme d'un épaulement mais peuvent prendre d'autres formes.

Ce contrôle du positionnement et de la distance entre le capteur de présence et la paroi permet de garantir les caractéristiques de détection du capteur de présence une fois qu'il est positionné en regard de la paroi.

Dans le cas d'un capteur fonctionnant sur la base d'une détection de variation de capacité, cela permet de garantir les caractéristiques - taille et forme - de la zone de détection créée.

De manière simplifiée, le capteur de présence pourra être maintenu sur la paroi par un clip ou tout autre moyen de fixation, par exemple issu de la paroi ou du capteur.

Pour que les différents éléments, matériau non conducteur et capteur de présence, soient fermement maintenus au niveau de la paroi, la pression exercée doit être suffisante. En effet, dans le cas où le système de détection de présence est embarqué à bord d'un véhicule, il est nécessaire que les moyens de fixation résistent aux vibrations, aux intempéries et autres conditions de fonctionnement.

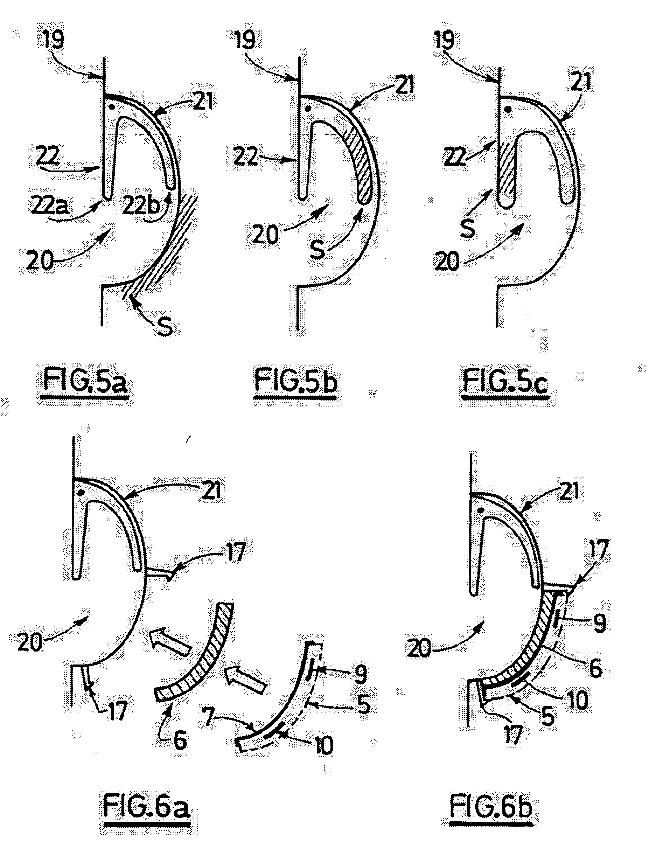

Les figures 5a, 5b et 5c présentent différentes solutions d'intégration d'un système de détection selon l'invention dans lequel la paroi forme une partie de poignée d'ouvrant.

On a représenté en coupe transversale un ouvrant 19 de véhicule automobile qui possède une poignée 20.

Cette poignée se compose d'un élément support 21 destiné à être positionné au niveau de l'ouvrant du véhicule et un élément de préhension 22 destiné à être manoeuvré par l'utilisateur lorsqu'il souhaite ouvrir l'ouvrant.

L'élément de préhension 22 possède deux parties : une partie avant 22a et une partie arrière 22b, l'utilisateur agrippant la partie avant 22a de la partie de préhension pour ouvrir l'ouvrant.

Dans un but de clarté, on a représenté, au niveau d'un poignée d'ouvrant, les différents emplacements possible du système de détection de présence S selon l'invention.

Ainsi, la figure 5a présente l'intégration du système de détection de présence S au niveau de l'élément support 21 de la poignée.

Dans la figure 5b, le système de détection de présence S est positionné dans la partie arrière 22b de l'élément de préhension 22.

La figure 5c présente quant à elle l'intégration du système de détection de présence S au niveau de la partie avant 22a de l'élément de préhension 22.

Dans le mode de réalisation consistant à intégrer le système de détection de présence dans une poignée d'ouvrant, le capteur de présence peut être un capteur d'approche et/ou un capteur tactile.

En effet, dans un mode de réalisation préférentiel, le capteur de présence intègre d'une part un capteur d'approche permettant de détecter l'approche d'un utilisateur au niveau de la poignée et d'autre part un capteur tactile permettant de détecter une action volontaire de toucher de l'utilisateur au niveau de la poignée.

De manière générale, dans les systèmes d'accès mains libres, le capteur d'approche est utilisé pour détecter l'approche de l'utilisateur en vue d'initier une communication entre l'identifiant et le système embarqué dans le véhicule alors que le capteur tactile est utilisé en vue de détecter une action volontaire de l'utilisateur lorsqu'il souhaite verrouiller le véhicule

Le choix du lieu d'intégration, au niveau de la poignée, du système de détection de présence sera fonction de l'architecture de celle-ci. En effet, selon la localisation des zones de détection souhaitées, on préfèrera une intégration au niveau du support de la poignée ou au niveau de sa partie de préhension.

Les figures 6a et 6b présentent des vues en coupe d'une poignée d'ouvrant intégrant un système de détection de présence selon l'invention et présentant son mode de fixation.

La figure 6a présente notamment une perspective d'assemblage du système de détection de présence et la figure 6b présente le système de détection de présence une fois en place au niveau de la poignée d'ouvrant.

La poignée d'ouvrant 20 intègre au niveau de cadre support 21 un capteur de présence 5 pour former un système de détection de présence selon l'invention. Ce système de détection de présence possède des moyens de fixation réalisés sous la forme de clips 17.

Ces clips sont issus du cadre support 21 et coopèrent avec le boîtier support 7 du capteur de présence 5 de sorte à maintenir en place d'une part, la couche isolante électriquement 6 et d'autre part, le capteur de présence 5 dans son boîtier support 7.

Sur les figures 6a et 6b, on visualise en coupe les électrodes de mesure 10 et de référence 9 du capteur de présence.

Selon l'invention, on a réalisé un système de détection de présence qui permet de réduire le risque de fausses détections et le risque de non détection et ne nécessite pas d'être positionné dans un logement étanche.

De plus, selon l'invention, le choix judicieux du matériau non conducteur permet de faciliter le montage du système et d'obtenir une bonne étanchéité du système entre la paroi et le capteur de présence, ou tout au moins, entre la paroi et la surface dite active du capteur de présence.

L'utilisation de moyen de fixation permet quant à lui de contrôler le positionnement du capteur de présence par rapport à la paroi et de garantir les caractéristiques de détection du capteur.

## Revendications

1. Système de détection de présence d'un utilisateur comprenant :
- un capteur de présence (5), de type capacitif, positionné en regard d'une surface interne (2) d'une paroi (1) accessible par sa surface externe (3) à l'utilisateur, ledit capteur présentant une surface active avec au moins une électrode (9,10) générant par couplage électromagnétique avec une seconde électrode, une zone de détection (4) de l'utilisateur,
- une couche électriquement isolante (6) d'au moins un matériau non conducteur (6a) remplissant totalement l'espace situé entre ladite surface interne (2) et au moins la surface active du capteur de présence (5) située en regard de manière à créer une étanchéité à l'introduction de toute matière conductrice susceptible de générer une perturbation du couplage électromagnétique au niveau de l'espace situé entre ladite surface interne (2) et la surface active du capteur de présence (5) en regard et éviter ainsi une modification non désirée de la zone de détection (4).
**caractérisé en ce qu'**il comprend en outre :
- des moyens de fixation (13-18) pour maintenir le capteur de présence (5) en regard de ladite surface interne (2) de la paroi (1), et
- des moyens (15) pour le positionnement du capteur de présence (5) à une distance prédéterminée de la surface externe (3) de la paroi (1), de sorte que la distance entre la surface externe (3) de la paroi et la surface du capteur de présence située en regard de la surface interne (2) soit approximativement constante.

2. Système de détection de présence selon la revendication 1, **caractérisé en ce que** la couche électriquement isolante (6) remplie totalement l'espace situé entre la surface interne (2) et l'ensemble de la surface du capteur de présence située en regard.

3. Système de détection de présence selon la revendication 1 ou 2, **caractérisé en ce que** le matériau non conducteur est un matériau souple et / ou malléable de manière à s'adapter d'une part, au profil de la surface interne (2) de la paroi (1) et d'autre part, au profil de la surface du capteur de présence située en regard.

4. Système de détection de présence selon l'une quelconque des revendications précédentes, **caractérisé en ce que** le matériau non conducteur (6a) est une mousse ou un film.

5. Système de détection de présence selon l'une quelconque des revendications précédentes, **caractérisé en ce que,** durant la phase de montage du système, le matériau non conducteur (6a) est introduit dans l'espace situé entre la surface interne (2) de la paroi (1) et la surface du capteur de présence située en regard, sous la forme d'un fluide polymérisant au contact de l'air ou thermodurcissable.

6. Système de détection de présence selon la revendication précédente, **caractérisé en ce que** les moyens de fixation (16,18) permettent d'exercer une pression sur la couche électriquement isolante (6) de sorte que celle-ci est maintenue en position.

7. Système de détection de présence selon l'une quelconque des revendications précédentes, **caractérisé en ce que** les moyens de fixation (16) et les moyens (15) pour le positionnement du capteur de présence (5) forment deux pièces indépendantes.

8. Système de détection de présence selon l'une quelconque des revendications précédentes 1 à 6, **caractérisé en ce que** les moyens de fixation (18) forment une pièce unique avec les moyens (15) pour le positionnement du capteur de présence (5).

9. Système de détection de présence selon l'une quelconque des revendications précédentes, **caractérisé en ce que** le matériau non conducteur (6a) présente des propriétés adhésives permettant, au moins partiellement, la fixation du capteur de présence (5) sur la surface interne de la paroi (2).

10. Système de détection de présence selon l'une quelconque des revendications précédentes, **caractérisé en ce que** la couche électriquement isolante (6) de matériau non conducteur est constituée d'un empilement de différents matériaux non conducteurs (6a).

11. Système de détection de présence selon l'une quelconque des revendications précédentes, **caractérisé en ce que** le capteur de présence (5) comprend un boîtier support (7) dont une face constitue la surface du capteur de présence située en regard de la surface interne (2) de la paroi (1) dans lequel sont intégrés au moins partiellement un module électronique de contrôle (8) et au moins une électrode (9, 10).

12. Système de détection de présence selon l'une quelconque des revendications précédentes, **caractérisé en ce que** le capteur de présence (5) est un capteur tactile permettant la détection d'une action de toucher d'un utilisateur au niveau de la surface externe (3) de la paroi en regard dudit capteur

13. Système de détection de présence selon l'une quelconque des revendications 1 à 11, **caractérisé en ce que** le capteur de présence (5) est un capteur d'approche permettant la détection d'un utilisateur dans une zone de détection de présence (4) située à proximité de la surface externe (3) de la paroi en regard dudit capteur.

14. Système de détection de présence selon l'une quelconque des revendications précédentes **caractérisé en ce que** la paroi (1) forme une partie de poignée d'ouvrant (20).

## Claims

1. User presence detection system comprising:
- a capacitive type presence sensor (5) positioned facing an internal surface (2) of a wall (1) accessible to the user through its external surface (3), said sensor having an active surface with at least one electrode (9,10) generating a user detection zone (4) by electromagnetic coupling with a second electrode,
- an electrically insulating layer (6) made of at least one non-conducting material (6a) completely filling the space between said internal surface (2) and at least the active surface of the presence sensor (5) facing it, so as to create a seal when any conducting material is inserted that could generate a disturbance to the electromagnetic coupling at the space located between said internal surface (2) and the active surface of the presence sensor (5) facing it and thus prevents unwanted modification of the detection zone (4).
**characterised in that** it also comprises:
- attachment means (13-18) to keep the presence sensor (5) in position facing said internal surface (2) of the wall (1), and
- means (15) of positioning the presence sensor (5) at a predetermined distance from the external surface (3) of the wall (1), such that the distance between the external surface (3) of the wall and the surface of the presence sensor located facing the internal surface (2) is approximately constant.

2. Presence detection system according to claim 1, **characterised in that** the electrically insulating layer (6) completely fills the space located between the internal surface (2) and the entire surface of the presence sensor facing it.

3. Presence detection system according to claim 1 or 2, **characterised in that** the non-conducting material is a flexible and/or malleable material capable of adapting to fit firstly the section of the internal surface (2) of the wall (1), and secondly the section of the surface of the presence sensor located facing it.

4. Presence detection system according to any one of the previous claims, **characterised in that** the non-conducting material (6a) is a foam or a film.

5. Presence detection system according to any one of the previous claims, **characterised in that** the non-conducting material (6a) is inserted into the space located between the internal surface (2) of the wall (1) and the surface of the presence sensor facing it during the system assembly phase, in the form of a fluid that polymerises in contact with the air or is thermosetting.

6. Presence detection system according to the previous claim, **characterised in that** the attachment means (16, 18) apply pressure on the electrically insulating layer (6) such that it is held in position.

7. Presence detection system according to any one of the previous claims, **characterised in that** the attachment means (16) and the means (15) for positioning the presence sensor (5) form two independent parts.

8. Presence detection system according to any one of the previous claims 1 to 6, **characterised in that** the attachment means (18) form a single piece with the means (15) for positioning the presence sensor (5).

9. Presence detection system according to any one of the previous claims, **characterised in that** the non-conducting material (6a) has adhesive properties that enable it to at least partially fix the presence sensor (5) on the internal surface of the wall (2).

10. Presence detection system according to any one of the previous claims, **characterised in that** the electrically insulating layer (6) of the non-conducting material is composed of a stack of different non-conducting materials (6a).

11. Presence detection system according to any one of the previous claims, **characterised in that** the presence sensor (5) comprises a support housing (7), of which one face forms the surface of the presence sensor located facing the internal surface (2) of the wall (1) in which an electronic control module (8) and at least one electrode (9, 10) are at least partially integrated.

12. Presence detection system according to any one of the previous claims, **characterised in that** the presence sensor (5) is a touch sensor capable of detecting an action by a user to touch it at the external surface (3) of the wall facing said sensor.

13. Presence detection system according to any one of claims 1 to 11, **characterised in that** the presence sensor (5) is an approach sensor capable of detecting a user within a presence detection zone (4) close to the external surface (3) of the wall facing said sensor.

14. Presence detection system according to any one of the previous claims, **characterised in that** the wall (1) forms a part of the opening handle (20).

## Patentansprüche

1. Anwesenheitserfassungseinrichtung zur Erfassung der Anwesenheit eines Benutzers umfassend:
- einen kapazitiven Anwesenheitssensor (5), der gegenüber einer Innenfläche (2) einer dem Benutzer von ihrer Außenfläche zugänglichen Wand (1) positioniert ist, wobei der Sensor eine aktive Fläche mit mindestens einer Elektrode (9, 10) aufweist, die mittels elektromagnetischer Kopplung mit einer zweiten Elektrode einen Erfassungsbereich (4) zum Erfassen eines Benutzers erzeugt,
- eine elektrisch isolierende Schicht (6) aus mindestens einem nicht leitenden Werkstoff (6a), die den Raum zwischen der Innenfläche (2) und mindestens der gegenüber liegenden aktiven Fläche des Anwesenheitssensors (5) ganz ausfüllt, um eine Abdichtung gegen das Eindringen jeder Art von leitendem Material zu bewirken, das eine Störung der elektromagnetischen Kopplung bei dem Raum zwischen der Innenfläche (2) und der gegenüber liegenden aktiven Fläche des Anwesenheitssensors (5) erzeugen kann, und damit eine unerwünschte Veränderung des Erfassungsbereiches (4) zu vermeiden,
**dadurch gekennzeichnet, dass** sie zudem umfasst:
- Befestigungsmittel (13-18) zur Halterung des Anwesenheitssensors (5) gegenüber der Innenfläche (2) der Wand (1) und
- Mittel (15) zum Positionieren des Anwesenheitssensors (5) in einem vorbestimmten Abstand zur Außenfläche der Wand (1), sodass der Abstand zwischen der Außenfläche (3) der Wand und der Oberfläche des Anwesenheitssensors, die der Innenfläche (2) gegenüber liegt, ungefähr konstant bleibt.

2. Anwesenheitserfassungseinrichtung nach Anspruch 1, **dadurch gekennzeichnet, dass** die elektrisch isolierende Schicht (6) den Raum zwischen der Innenfläche (2) und der gesamten gegenüber liegenden Oberfläche des Anwesenheitssensors ganz ausfüllt.

3. Anwesenheitserfassungseinrichtung nach Anspruch 1 oder 2, **dadurch gekennzeichnet, dass** der nicht leitende Werkstoff ein weicher und/oder plastischer Werkstoff ist, sodass er sich an das Profil der Innenfläche (2) der Wand (1) einerseits und an das Profil der gegenüber liegenden Oberfläche des Anwesenheitssensors anpasst.

4. Anwesenheitserfassungseinrichtung nach einem der vorhergehenden Ansprüche, **dadurch gekennzeichnet, dass** der nicht leitende Werkstoff (6a) ein Schaum oder eine Folie ist.

5. Anwesenheitserfassungseinrichtung nach einem der vorhergehenden Ansprüche, **dadurch gekennzeichnet, dass** der nicht leitende Werkstoff (6a) während der Einbauphase der Einrichtung in den Raum zwischen der Innenseite (2) der Wand (1) und der gegenüber liegenden Oberfläche des Anwesenheitssensors in Form eines in Berührung mit Luft polymerisierenden oder warm härtenden Mediums eingeführt wird.

6. Anwesenheitserfassungseinrichtung nach dem vorhergehenden Anspruch, **dadurch gekennzeichnet, dass** mit den Befestigungsmitteln (16, 18) ein Druck auf die elektrisch isolierende Schicht (6) zu deren Halterung ausgeübt werden kann.

7. Anwesenheitserfassungseinrichtung nach einem der vorhergehenden Ansprüche, **dadurch gekennzeichnet, dass** die Befestigungsmittel (16) und die Mittel (15) zum Positionieren des Anwesenheitssensors (5) zwei voneinander unabhängige Teile bilden.

8. Anwesenheitserfassungseinrichtung nach einem der vorhergehenden Ansprüche 1 bis 6, **dadurch gekennzeichnet, dass** die Befestigungsmittel (18) und die Mittel (15) zum Positionieren des Anwesenheitssensors (5) einstückig ausgebildet sind.

9. Anwesenheitserfassungseinrichtung nach einem der vorhergehenden Ansprüche, **dadurch gekennzeichnet, dass** der nicht leitende Werkstoff (6a) Hafteigenschaften aufweist, mit denen der Anwesenheitssensor (5) mindestens teilweise an der Innenfläche der Wand (2) angebracht werden kann.

10. Anwesenheitserfassungseinrichtung nach einem der vorhergehenden Ansprüche, **dadurch gekennzeichnet, dass** die elektrisch isolierende Schicht (6) aus nicht leitendem Werkstoff aus einem Stapel unterschiedlicher nicht leitender Werkstoffe (6a) besteht.

11. Anwesenheitserfassungseinrichtung nach einem der vorhergehenden Ansprüche, **dadurch gekennzeichnet, dass** der Anwesenheitssensor (5) ein Traggehäuse (7) umfasst, bei dem eine Fläche die der Innenfläche (2) der Wand (1) gegenüber liegende Oberfläche des Anwesenheitssensors bildet, die, in dem mindestens teilweise ein elektronisches Kontrollmodul (8) und mindestens eine Elektrode (9, 10) untergebracht sind.

12. Anwesenheitserfassungseinrichtung nach einem der vorhergehenden Ansprüche, **dadurch gekennzeichnet, dass** der Anwesenheitssensor (5) ein Berührungssensor ist, mit dem ein Berühren durch einen Benutzer der Außenfläche (3) der dem Sensor gegenüber liegenden Wand erfasst werden kann.

13. Anwesenheitserfassungseinrichtung nach einem der Ansprüche 1 bis 11, **dadurch gekennzeichnet, dass** der Anwesenheitssensor (5) ein Näherungssensor ist, mit dem in einem Anwesenheitserfassungsbereich (4) in der Nähe der Außenfläche (3) der dem Sensor gegenüber liegenden Wand ein Benutzer erfasst werden kann.

14. Anwesenheitserfassungseinrichtung nach einem der vorhergehenden Ansprüche, **dadurch gekennzeichnet, dass** die Wand (1) einen Teil eines Türgriffs (20) bildet.
